# EUROPÄISCHE PATENTSCHRIFT

(11) **EP 2 859 581 B1**
(45) Veröffentlichungstag und Bekanntmachung des Hinweises auf die Patenterteilung: **24.02.2016**
(21) Anmeldenummer: 12730184.4
(22) Anmeldetag: 12.06.2012
(51) Int. Cl.: H01L 21/67, H01L 21/683

(54) **VERFAHREN ZUR HERSTELLUNG EINER SUBSTRAT-PRODUKTSUBSTRAT-KOMBINATION**
METHOD FOR PRODUCING A SUBSTRATE-PRODUCT SUBSTRATE COMBINATION
PROCÉDÉ POUR PRODUIRE UNE COMBINAISON SUBSTRAT-SUBSTRAT PRODUIT

(43) Veröffentlichungstag der Anmeldung: 15.04.2015
(73) Patentinhaber: Thallner, Erich, 4782 St. Florian (AT)
(72) Erfinder: Thallner, Erich, 4782 St. Florian (AT)
(74) Vertreter: Schweiger, Johannes
(86) Internationale Anmeldenummer: PCT/EP2012/061117
(87) Internationale Veröffentlichungsnummer: WO 2013/185804

(56) Entgegenhaltungen:
- EP-A1- 1 564 804
- EP-A1- 1 775 757
- EP-A2- 0 989 616
- US-A1- 2002 016 135
- US-A1- 2006 292 887
- US-A1- 2007 020 871
- US-B1- 6 910 403
- US-B2- 7 195 988

## Beschreibung

Die vorliegende Erfindung betrifft ein Verfahren zur Herstellung einer Substrat-Produktsubstrat-Kombination nach Anspruch 1.

Das Rückdünnen von Substraten, insbesondere Wafern, ist in der Halbleiterindustrie häufig erforderlich und kann mechanisch und/oder chemisch erfolgen. Zum Rückdünnen werden die Wafer in der Regel auf einem Trägersystem vorübergehend fixiert, wobei es bei der Fixierung verschiedene Methoden gibt. Als Trägersystem werden beispielweise Folien oder Wafer aus Silizium, Siliziumlegierungen wie SiC, SiN etc., Keramiken, (glasfaserverstärkten) Kunststoffen, Graphit, Saphir, Metallen, Gläsern oder Verbundwerkstoffen verwendet. Am Ende des Rüekdünnvorganges und der Nachbearbeitung werden die rückgedünnten Wafer auf Filmrahmen montiert und anschließend wird der Träger entfernt.

Sobald eine über das Rückdünnen hinausgehende Bearbeitung des Substrates nötig ist, kommen wiederum starre Trägersysteme, nämlich Trägersubstrate, zum Einsatz. Beispiele für solche Bearbeitungsschritte auf entsprechenden Industrieanlagen nach dem Rückdünnen sind: Metallisierung, Trockenätzen, Nassätzen, Laserbearbeitung, Lithographie, Ofenprozesse, Dotierung etc.

Bei einem starren Trägersubstrat wird das zu bearbeitende Produktsubstrat typischerweise durch eine Klebeschicht mit dem Trägersubstrat verbunden.

Das Trägersubstrat soll dem beliebig dünnen zu bearbeitenden Substrat ausreichend mechanische Stabilität verleihen, um in weiterführenden Prozessschritten beziehungsweise Prozessvorrichtungen bearbeitet werden zu können. Zieldicken sind heutzutage im Falle einer temporären Verbindung: zwischen 30 und 100 µm, in Zukunft werden dünnere Produktsubstrate angestrebt zwischen 1 µm und 50 µm, im Falle einer permanenten Verbindung sind noch dünnere Produktsubstrate möglich welche physisch nur noch durch die Anforderungen an die Bauhöhe eines Transistors mit Verbindungen limitiert sind. Die minimalen Dicken eines Produktsubstrats liegen zwischen 0,001 µm und 5 µm.

Einige der vorgenannten Bearbeitungsschritte erfordern eine exakte Positionierung der Substrate beziehungsweise des Trägers innerhalb der entsprechenden Vorrichtungen.

Dabei werden beispielsweise Produktsubstrate mit nominell 300 mm +/- 200µm auf Trägersubstrat mit 301 mm +/-200µm gebondet. Dies geschieht aus Vorsichtsmaßnahme, um den rückzudünnenden oder rückgedünnten Wafer im Randbereich ausreichend zu schützen und insbesondere zu unterstützen. Durch diese Maßnahme liegt das Trägersubstrat im Randbereich bei verschiedenen Bearbeitungsschritten, insbesondere bei Sputtervorgängen, galvanischer Abscheidung, Ätzprozessen, allerdings frei.

Durch die, im Stand der Technik erwähnten Trägersubstrate kommt es zu einigen Problemen. Abscheidungsprozesse, Anätzungen am Rande des Trägersubstrats etc. führen dazu, dass die Trägersubstratkante stark verunreinigt wird.

Nach dem Ablösen vom Produktsubstrat muss dieser kontaminierte Randbereich sehr aufwendig und kostenintensiv gereinigt werden. Oft ist die defekte Trägersubstratkante der einzige Grund, welcher die Lebensdauer des Trägersubstrats beschränkt. Die Zusatzkosten für ein Endprodukt ergeben sich unter anderem aus den Kosten des Trägersubstrats, dessen Recyclingkosten und der Anzahl der Wiederverwendungszyklen. Durch dieses bisher angewandte Verfahren wird ein Reinigungsschritt des Trägersubstrats sehr teuer, so dass in vielen Fällen das Trägersubstrat nicht wiederverwendet wird.

Je günstiger das Trägersubstrat desto weniger kritisch ist eine geringe Anzahl Wiederverwendungszyklen, beispielsweise sind mindestens zehn Wiederverwendungen für Trägersubstratherstellkosten um 20€ gewünscht.

Je teurer der Trägersubstrat desto wichtiger ist seine hohe Lebensdauer (=große Anzahl von Wiederverwendungszyklen). Beispielsweise sind 1000 Wiederverwendungen für Trägersubstratherstellkosten um 2000€ gewünscht.

Eigenschaften die ein Trägersubstrat in der ersten Herstellung teuer machen können sind z.B.:
- Ausgangsmaterial,
- Präzise Geometrie: Geringes TTV (Total Thickness Variation), z.B. <1µm erforderlich um das Produkt möglichst präzise auf die gewünschte Dicke schleifen und polieren zu können,
- Vorbehandlungen die ein nachfolgendes Lösen des Temporären Bonds ermöglichen.

Durch diese Probleme werden sehr teure Trägersubstrate häufig überhaupt nicht angewendet, obwohl sie für andere Prozessschritte nützliche Eigenschaften hätten.

Aus dem US2006/0292887 ist ein Verfahren zum Rückdünnen eines auf einem Trägersubstrat gestützten Halbleiterwafer bekannt, bei dem der Trägersubstrat kleiner ist als der Halbleiterwafer.

Bei den nachfolgend aufgeführten Prozessschritten bestehen sehr hohe Anforderungen an die Genauigkeit der Zuordnung zweier Wafer gefordert:
- Bei Plasmabearbeitung rückgedünnter Wafer auf Trägersubstraten bewirkt eine Exzentrizität eine Entladungsungleichmäßigkeit des Plasmas. Entstehende Entladungen (Durchschläge aufgrund hoher elektrischer Felddichte - Arcing) können Schäden an Produkt und Plasmaprozesskammer verursachen. Durch die Möglichkeit, ein Trägersubstrat gleich/kleiner als das Produktsubstrat zu verwenden, werden besondere Vorteile bei Plasma und Sputterprozessen erreicht.
- Bei der lithografischen Belichtung auf sogenannten Scannern und Steppern werden unzureichend justierte Bondpaare nicht ausreichend genau geladen. Die Referenzierung (Vorausrichtung) des Bondpaars erfolgt aufgrund der Außenkontur. Die Außenkontur eines (viel) größeren Trägersubstrats korrespondiert jedoch nicht mit der Lage der Passmarken auf dem Produktsubstrat solange die Justierung der beiden Außenkonturen nicht präzise ist, bzw. die Außenkontur des Produktsubstrats nicht verwendet werden kann. Die Passmarken sind damit nicht im "Fangbereich" der Mikroskope und müssen aufwendig gesucht werden. Das führt zu Zeit-, Durchsatz- und Produktivitätsverlust an diesen Systemen.

Aufgabe der vorliegenden Erfindung ist es daher, ein optimiertes Verfahren zum Herstellen einer Substrat- Trägersubstrat-Kombination anzugeben.

Diese Aufgabe wird mit den Merkmalen des Anspruchs 1 gelöst. Bei angegebenen Wertebereichen sollen auch innerhalb der genannten Grenzen liegende Werte als Grenzwerte offenbart sein.

Der Erfindung liegt der Gedanke zugrunde, durch Vorsehen eines Substrats mit einem größeren Durchmesser d1 als der Durchmesser d2 des Trägersubstrats beim Kontaktieren das erfindungsgemäße Verfahren zu optimieren. Eine Vorrichtung, die keinen Teil der Erfindung darstellt, wird außerdem beschrieben, mit der das Verfahren ausführbar ist. Dabei ist es insbesondere denkbar, eine, insbesondere elektronische, Erfassung (Erfassungsmittel) von Außenkonturen der auszurichtenden und kontaktierenden Substrate sowie Verarbeitung (Steuerungsmittel) der erfassten Außenkonturen in Steuerungssignale zur Ausrichtung (Ausrichtungsmittel) der Substrate eine exaktere Ausrichtung zu erreichen. Dabei ist es außerdem möglich, dass die Ausrichtung während eines Aufeinander-zu-Bewegens zur Kontaktierung der Substrate, vorzugsweise kontinuierlich erfolgt. Darüber hinaus ist es insbesondere denkbar, die Ausrichtungsgenauigkeit mit denselben Erfassungsmitteln zu überprüfen und gegebenenfalls eine erneute Ausrichtung durchzuführen.

Die Durchmesser d1 und/oder d2 werden parallel zur Kontaktseite oder Stützfläche gemessen, wobei diese als mittlere Durchmesser d1 und/oder d2 (gemittelt entlang der Umfangskonturen des Substrats/Trägersubstrats) zu sehen sind. Bezogen auf den Querschnitt des Substrats/Trägersubstrats und die jeweilige Querschnittskontur sind die mittleren Durchmesser dl/d2 am jeweiligen Maximum der Querschnittskontur gemessen. Idealerweise sind das Substrat und das Trägersubstrat exakt kreisrund, so dass die Durchmesser d1/d2 am Umfang nicht voneinander abweichen.

Unter Substraten werden in der Halbleiterindustrie verwendete Produkt- oder Trägersubstrate verstanden. Das Trägersubstrat dient als Verstärkung des Funktionssubstrates (Produktsubstrat) bei den verschiedenen Bearbeitungsschritten, insbesondere beim Rückdünnen des Funktionssubstrates. Als Substrate kommen insbesondere Wafer, entweder mit Abflachung ("flat") oder Einkerbung ("notch"), in Frage.

Ein Produkt (beziehungsweise eine Substrat-Trägersubstrat-Kombination) wird außerdem vorgesehen, welches aus einem Trägersubstrat und einem Substrat besteht, die mit der Vorrichtung und/oder dem erfindungsgemäßen Verfahren ausgerichtet, kontaktiert und miteinander vorfixiert und/oder gebonded worden sind und sich insbesondere dadurch auszeichnen, dass der Durchmesser d2 des Trägersubstrats minimal geringer ist als der Durchmesser d1 des Produktsubstrats. Damit wird sichergestellt, dass das Trägersubstrat während der Prozessierung des Produktsubstrats keinerlei Kontamination, Verschmutzung, ungewollter Behandlung etc. ausgesetzt wird und daher öfter wiederverwendet werden kann.

Gemäß der Erfindung wird das Substrat nach dem Kontaktieren rückgedünnt, wobei der Durchmesser d1 durch die Form des Querschnitts des Substrats an dessen Umfangskontur auf d1 <= d2 verringert wird. Dadurch wird die einfache Weiterverarbeitung der Substrat-Trägersubstratkombination, insbesondere auf bekannten und standardisierten Anlagen, ermöglicht.

Die hierin beschriebene Vorrichtung wird insbesondere dadurch weitergebildet, dass die Erfassungsmittel die Form des Querschnitts des Substrats an dessen Umfangskontur erfassend ausgebildet sind derart, dass das Rückdünnen des Substrats so steuerbar ist, dass der Durchmesser d1 verringert wird, insbesondere auf d1 <= d2. Durch die Erfassung der Form des Querschnitts, insbesondere eines Profils der Querschnittskontur von der Seite betrachtet, also entlang der Dicke D1 des Substrats, kann insbesondere eine exakte Steuerung des Rückdünnprozesses erfolgen.

Indem die Erfassungsmittel gegenüber dem Substrat und/oder gegenüber dem Trägersubstrat durch Rotationsmittel rotierbar und/oder gegenüber dem Substrat und/oder gegenüber dem Trägersubstrat durch eine Verstelleinrichtung in X- und/oder Y-Richtung parallel zur Kontaktierungsebene verstellbar sind, ist die Ausrichtung effizient und präzise ausführbar.

Gemäß einer vorteilhaften Weiterbildung ist vorgesehen, dass die Erfassungsmittel an einer zumindest abschnittsweise umfangsseitig zum Substrat und/oder Trägersubstrat anordenbaren, insbesondere abschnittsweise ringförmig ausgebildeten, Trägereinheit angebracht sind. Damit ist eine Integration der Erfassungsmittel in effizienter Weise möglich.

Mit Vorteil ist die Trägereinheit zwischen der Trägersubstrataufnahme und der Substrataufnahme angebracht, insbesondere mit dazwischen angebrachten Kontaktierungsmitteln, vorzugsweise in Form einer Z-Verstelleinheit, und/oder mit dazwischen angebrachter Grundplatte. Auf diese Weise ist eine besonders effiziente Ausgestaltung vorgesehen.

Dabei ist es von Vorteil, wenn die Verstelleinrichtung, insbesondere unmittelbar, zwischen der Grundplatte und der Trägereinheit angebracht ist. Somit ist eine unmittelbare Einwirkung auf die Trägereinheit, insbesondere zusammen mit der daran angebrachten Substrataufnahme, denkbar.

Gemäß einer weiteren, vorteilhaften Weiterbildung ist vorgesehen, dass die Umfangskontur und die Umfangskontur, insbesondere gleichzeitig, mit denselben, insbesondere einem oder mehreren Erfassungsmitteln, vorzugsweise Mikroskopen, erfassbar sind. Auf diese Weise lässt sich die Anzahl der teuren Erfassungsmittel ohne Geschwindigkeitseinbußen reduzieren.

Die Ausrichtung eines Substrates kann auch zu einem Substratstapel als Trägersubstrat erfolgen. Dabei versteht man unter einem Substratstapel eine Menge bereits bearbeiteter, beispielsweise rückgedünnter, Substrate, die, insbesondere permanent, miteinander gebonded sind. Dieser Substratstapel kann, wenn er dick genug ist, als Trägersubstrat dienen.

Besonders bevorzugt ist die Verwendung einer mechanischen Ausrichtungseinrichtung (Verstelleinrichtung und Rotationsmittel) sowohl für das Substrat als auch für das Trägersubstrat in Verbindung mit einem optischen Distanzmesssystem. Hierbei ist es von besonderem Vorteil, wenn diese Ausrichtungseinrichtung in einer Anlage zum Bonden oder Vorfixieren der Substrate integriert angeordnet ist.

Somit wird eine exakte, schnelle und kostengünstige Ausrichtung zweier Substrate (Substrat und Trägersubstrat) zueinander erlaubt, ohne auf Ausrichtungsmarken Bezug nehmen zu müssen. Trägersubstrate können daher auf Ausrichtungsmarken verzichten, so dass diese günstiger herstellbar sind.

Außerdem ist dadurch eine mehrmalige Verwendung des Trägersubstrats möglich, ohne dieses durch aufwändige und teure Prozesse reinigen zu müssen.

Darüber hinaus ergibt sich die Möglichkeit, die Vorrichtung in einen Bonder einzubauen/zu integrieren.

So werden die unterschiedlichen Durchmesser der Substrate an mehreren Punkten des Umfangs (Umfangskonturen) berücksichtigt und eine genauere Positionierung ermöglicht, die bei anderen mechanischen und/oder optischen Positionierungen nicht möglich sind. Gleichzeitig wird eine schnellere Ausrichtung als bei (rein) mechanischer Ausrichtung ermöglicht.

Das Verfahren und die Vorrichtung sind in der Lage, die erforderlichen Genauigkeiten, insbesondere <50µm, zu ermöglichen und insbesondere eine höhere Rotationsgenauigkeit am Umfang, die bei bisherigen mechanischen Verfahren ein Schwachpunkt ist, zu erreichen. Es können sehr genau Einkerbungen am Umfang der Substrate (sogenannte "notches") von Substrat und Trägersubstrat zugeordnet werden.

Mit besonderem Vorzug befinden sich die Einkerbungen, in einer solchen Position, dass sie von mindestens einem Erfassungsmittel detektiert werden. Jenes Erfassungsmittel, dessen Messrichtung parallel oder beinahe parallel, zur Substratnormalen ist, kann durch die Position der Einkerbungen besonders schnell eine rotatorische Missorientierung feststellen. Analoge Überlegungen gelten für Substrate mit flats oder jeder beliebigen anderen Einkerbung oder Abweichung von einer vorgegebenen Idealgeometrie des betreffenden Substrats, welche zur rotatorischen Ausrichtung herangezogen werden kann.

Das Verfahren ist insbesondere ein dynamisches, optisches Scanverfahren mit Softwaregesteuerter Optimierung der erfassten/gemessenen Daten.

In einer vorteilhaften Ausführung ist vorgesehen, das Trägersubstrat und das Funktionssubstrat an jeweils an gesonderten, mechanisch bewegbaren Haltevorrichtungen (Substrataufnahme/Trägersubstrataufnahme) zu fixieren. Hierbei sind insbesondere Chucks mit Vakuumhalterung vorgesehen. Es können aber auch andere Halterungen, wie adhäsive Materialien, mechanisches Klemmen oder elektrostatische Halterungen vorgesehen sein. Ebenso können an Stelle des Trägersubstrates auch Produktionssubstrate vorgesehen werden. Auch bereits mehrfach gebondete oder rückgedünnte Mehrschichtsubstrate können mit diesem Verfahren justiert/ausgerichtet werden.

Vorteilshaft wird eines der beiden Substrate auf einer in z Richtung beweglichen Befestigungseinrichtung (insbesondere Trägersubstrataufnahme) fixiert. Das andere Substrat auf einen drehbaren Chuck (insbesondere Substrataufnahme). Dieser ist in einer mechanischen Verstelleinheit (insbesondere Trägereinheit) befestigt, die in x und y Richtung verstellbar ist. An/In dieser mechanischen Verstelleinheit befinden sich ein oder mehrere optische Scaneinheiten (Erfassungsmittel), die die beiden Substrate, insbesondere gleichzeitig, in einem schmalen Bandbereich in vertikaler Richtung erfasst (scannt). Dadurch entsteht ein Abstandsprofil, das gleichzeitig die Außengeometrie (Umfangskonturen) der beiden Substrate erfasst/misst. Dieses Abstandsprofil ergibt insbesondere den größten äußeren Durchmesser des jeweiligen Substrates als auch den Abstand der einzelnen Substrate an den Messpunkten oder Messabschnitten zueinander.

Vorteilshalber rotieren diese Scaneinheiten der Erfassungsmittel in der mechanischen Verstelleinheit in der oder parallel zu der Kontaktierungsebene, um eine Erfassung mehrerer Umfangsabschnitte der Umfangskonturen der Substrate zu ermöglichen. Durch die Rotation der Scaneinheiten ist es möglich die Außengeometrie der beiden Substrate zu vermessen und zugleich die Lage der beiden Substrate zueinander zu ermitteln. Die Rotation kann einen Vollkreis beschreiben oder auch nur Sektoren/Erfassungsabschnitte. Für weniger genaue Justieranforderungen kann auf die Rotation der Scaneinheiten verzichtet werden. Es ist auch möglich die Scaneinheiten nicht zu rotieren, sondern die beiden Substrate bei feststehenden Scaneinheiten zu rotieren.

Alternativ können auch mehrere Scaneinheiten stationär um die beiden Substrate angeordnet sein, insbesondere mindestens 3, um die Lage und Durchmesser der beiden Außenkonturen (oder softwaremäßig entsprechend idealisierten Kreise) zu determinieren. In diesem Fall kann eine Rotation von Substraten und/oder Scaneinheiten entfallen. Eine geringfügige Rotation eines Substrates relativ zum anderen ist in diesem Fall ausreichend, um die notches oder das flat in Rotationsrichtung in der Kontaktierungsebene auszurichten.

Alternativ können die Scaneinheiten von oben oder unten, ungefähr im rechten Winkel zur Substratebene angeordnet sein und die Kanten der Umfangskonturen der Substrate detektieren. Im Spezialfall handelt es sich um Mikroskope, die ein optisches Bild der beiden Waferkanten zur Messung und Auswertung liefern.

Eines oder mehrere dieser Mikroskope können beweglich (rotierend um fixierte/stehende Substrate) oder stationär (mit rotierenden Substraten) angeordnet sein.

In einem weiteren Spezialfall sind mindestens drei Mikroskope stationär am Umfang über und/oder unter den Substraten angeordnet. Beide Umfangskanten sind über die Mikroskope sichtbar (ggf. unter umfokussieren aufgrund des Z-Abstandes (quer zur X- und Y-Richtung beziehungsweise Kontaktierungsebene), der die Tiefenschärfe übersteigen könnte. Das Substrat mit dem größeren Durchmesser, das die Sicht auf die Umfangskante des kleineren Substrats verdecken könnte, kann durch die Ausrichtungsmittel eine bestimmte Strecke bewegt und so sichtbar und positionierbar gemacht werden. Die Bildinformation der beiden Umfangskanten wird in eine Positionsinformation umgewandelt und die Substrate können zueinander präzise ausgerichtet werden.

Durch Software kann die notwendige Berechnung der Verstellwege der mechanischen Stellelemente (Ausrichtungsmittel) in X- und Y-Richtung sowie die notwendige Rotation der Substrate errechnet werden. Diese Berechnung und Messung kann während der Z Bewegung (Kontaktiermittel), also des mechanischen Zusammenfahrens der beiden Substrate, kontinuierlich gemessen und allenthalben korrigiert werden.

Durch dieses online-Messverfahren ist es möglich, eventuelle Abweichungen während oder nach dem Zusammenfügen der Substrate zu korrigieren oder durch Auseinenderbewegen und erneutes Ausrichten und Kontaktieren zu optimieren.

Durch die Vorrichtung und das Verfahren ist es möglich, auch stark unterschiedliche Substrate, wie unterschiedliche Durchmesser oder unterschiedliche Geometrie, zum Beispiel runde Substrate zu rechteckigen Substraten, genau auszurichten.

Weitere Vorteile, Merkmale und Einzelheiten der Erfindung ergeben sich aus der nachfolgenden Beschreibung sowie anhand der Zeichnungen. Diese zeigen in:
- Fig. 1a: eine schematische Querschnittsansicht einer Vorrichtung in einer ersten Ausführungsform,
- Fig. 1b: eine schematische Aufsicht auf die Vorrichtung gemäß Fig. 1a,
- Fig. 2a: eine schematische Querschnittsansicht einer Vorrichtung in einer zweiten Ausführungsform,
- Fig. 2b: eine schematische Aufsicht auf die Vorrichtung gemäß Fig. 2a,
- Fig. 3a: eine schematische Querschnittsansicht eines Prozessschrittes eines Ausführungsbeispiels der Erfindung vor dem Bondschritt,
- Fig. 3b: eine schematische Querschnittsansicht eines Prozessschrittes eines Ausfiihrungsbeispiels der Erfindung nach dem Bondschritt,
- Fig. 3c: eine schematische Querschnittsansicht eines Prozessschrittes eines Ausführungsbeispiels der Erfindung nach dem Rückdünnen,
- Fig. 4a: eine schematische Querschnittsansicht eines Prozessschrittes vor dem Bondschritt,
- Fig. 4b: eine schematische Querschnittsansicht eines Prozessschrittes nach dem Bondschritt und
- Fig. 4c: eine schematische Querschnittsansicht eines Prozessschrittes nach dem Rückdünnen.

In den Figuren sind Vorteile und Merkmale mit diese jeweils identifizierenden Bezugszeichen gekennzeichnet, wobei Bauteile beziehungsweise Merkmale mit gleicher oder gleichwirkender Funktion mit identischen Bezugszeichen gekennzeichnet sind.

Die Figuren zweigen jeweils eine Vorrichtung und ein Verfahren, welche es ermöglichen, Substrate 2, 5 (oder Substratstapel) über Umfangskanten 2u, 5u zueinander auszurichten. Bei dem Verfahren handelt es sich um ein dynamisches, optisches Scanverfahren mit Softwareoptimierung der gemessenen Daten.

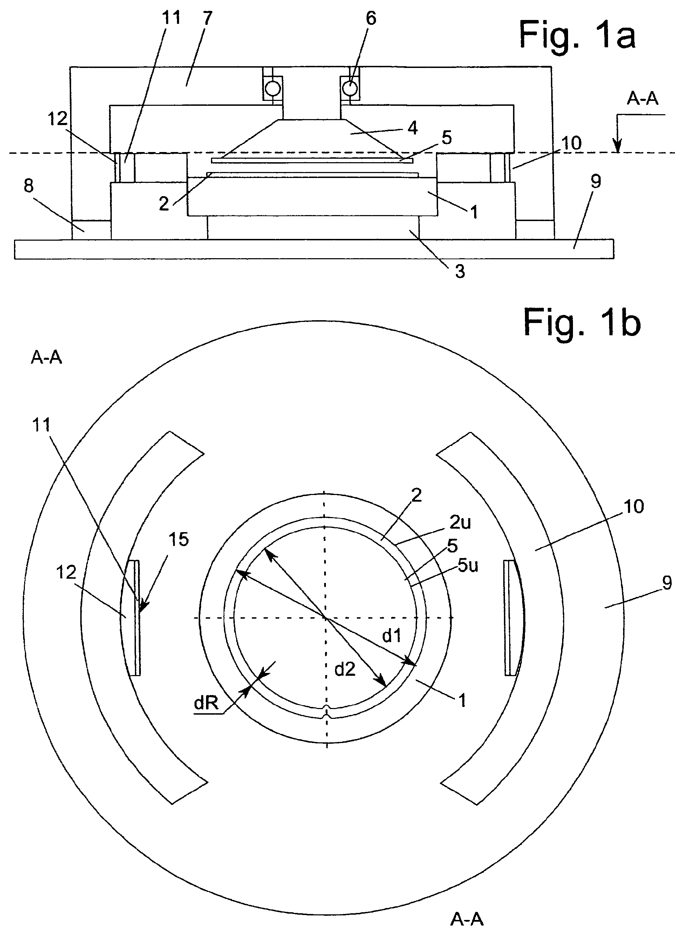

In Fig. 1a und 1b ist auf einer Substrataufnahme 1 (Chuck) ein Produktsubstrat als Substrat 2 fixiert. Die Substrataufnahme 1 ist über eine Verstelleinheit 3 (Kontaktierungsmittel) in Z Richtung verstellbar, also quer zu einer Kontaktierungsebene zwischen dem Substrat 2 und einem Trägersubstrat 5.

Oberhalb der Substrataufnahme 1 befindet sich ein weiterer Chuck (Trägersubstrataufnahme 4) mit dem darauf fixierten Trägersubstrat 5. Die Trägersubstrataufnahme 4 ist über eine Rotationsführung (Rotationsmittel 6) mit einer mechanischen Einheit (Trägereinheit 7) verbunden. Diese mechanische Trägereinheit 7 ist auf einer Grundplatte 9 über Führungen (Verstelleinrichtung 8 zur Verstellung in X- und Y- Richtung) verbunden. Diese Verstelleinrichtung 8 ermöglicht es, dass die mechanische Trägereinheit 7 in X und Y-Richtung bewegt werden kann, und zwar gesteuert über eine nicht dargestellte Steuerungseinrichtung.

Technisch gesehen kommt es nur auf die Möglichkeit an, eine Relativbewegung zwischen den Substraten 2, 5 zu bewirken.

Diese Trägereinheit 7 weist ein, insbesondere ringförmiges, vorzugsweise kreisrundes, Führungselement 10 auf. An dem Führungselement 10 befindet sich ein Entfernungsmesselement 11 (Erfassungsmittel). Die Erfassungsmittel sind vorteilshaft in der Kontaktierungsebene der beiden Substrate 2, 5 positioniert und durch das Entfernungsmesselement werden in einem bestimmten Winkelbereich alle Entfernungen gemessen/erfasst. Dadurch entsteht in diesen gescannten Winkelbereich ein Entfernungsprofil, das der augenblicklichen Position der Scaneinheit (Erfassungsmittel) die Position der Substrate 2, 5 zuordnet.

Im Bereich des kreisrunden Führungselementes 10 weisen die Erfassungsmittel insbesondere zusätzliche Messmittel 12 auf. Die Messmittel 12 definieren die genaue Position der Scaneinheit 11 zum Umfang der Substrate 2, 5. Vorteilhaft befindet sich eine Auswerteeinheit der Messmittel 12 in den zugeordneten Entfernungsmesselementen integriert. Dies ist insbesondere von Vorteil, wenn mehrere Entfernungsmesselemente verwendet werden.

In einem eigenständigen Beispiel wird dabei ein Trägersubstrat 5 verwendet, welches einen geringfügig kleineren Durchmesser d2 als der Durchmesser d1 des Produktsubstrats 2 besitzt. Damit wird das Trägersubstrat 5, vor allem die Trägersubstratkante (Umfangskante 5u), vor weiteren Prozessschritten geschützt, und das Trägersubstrat 5 ist, vorzugsweise mehrmals, ohne weiteren Reinigungsschritt verwendbar. Es können damit auch sehr teure und komplexe Trägersubstrate 5 vielfach verwendet werden.

Wird das Trägersubstrat 5, statt wie bisher in der Halbleiterindustrie üblich, nicht größer sondern kleiner (oder im Rahmen der Fertigungstoleranzen gleich groß) als das Produktsubstrat 2 verwendet, erübrigt sich jeder Reinigungsvorgang der Trägersubstratkante 5u und der Randbereich des Trägersubstrats 5 bleibt frei von Kontamination, da das Produktsubstrat 2 als Abdeckung des Trägersubstrats 5 und/oder der Trägersubstratkante 5u dient und dieses Trägersubstrat 5 den Einflüssen der Bearbeitung nicht ausgesetzt ist. Das Trägersubstrat 5 kann daher ohne Reinigungsschritt wiederverwendet werden.

Die Differenz zwischen dem (mittleren) Durchmesser d1 des Produktsubstrats 2 und dem (mittleren) Durchmesser d2 des Trägersubstrats 5 ist kleiner als 500µm, vorzugsweise kleiner 400µm, mit größerem Vorzug kleiner als 300µm, mit größtem Vorzug kleiner als 200µm, mit allergrößtem Vorzug kleiner als 100µm.

Im Falle von gleich großen Produkt- und Trägersubstratdurchmessern kann durch Fertigungstoleranzen auch ein Fall eintreten, bei dem der Durchmesser d2 des Trägersubstrats 5 minimal (innerhalb der Fertigungstoleranz) größer ist als der Durchmesser d1 des Produktsubstrats 2 ist. Wichtig ist, dass ein Schutz der Trägersubstratkante 5u ausreichend gegeben ist durch die Abschattungswirkung der Produktsubstratkante 2u des, in diesem Falle, kleineren Produktsubstrats 2 (nicht eingezeichnet).

Um die geforderte Genauigkeit der Randüberdeckung zu erreichen, ist die Randübereinstimmung (Randüberstand des Produktsubstrats 2) insbesondere auf 5 µm bis 10 µm genau (konzentrisch). Mit anderen Worten weichen die Abstände der Umfangskanten 2u, 5u in radialer Richtung vom Zentrum der Substrate 2, 5 aus maximal um die obigen Werte voneinander ab.

Das Trägersubstrat 5 ist um 0 µm bis 500 µm kleiner als das Produktsubstrat 2, so dass die mechanische Unterstützung des mechanisch kritischen Randbereiches 2u des Produktsubstrates 2 ausreichend erhalten bleibt.

Aus Kosten- und Durchsatzgründen ist eine Positionierung an Passmarken im Inneren des Trägersubstrats 5 vorzugsweise nicht vorgesehen. Daher erfolgen erfindungsgemäß alle Justierungen zwischen strukturiertem Produkt- und unstrukturiertem Trägersubstrat nach den Substratkanten 2u, 5u der Substrate 2, 5.

Da die Substratkanten 2u, 5u der Substrate 2,5 mit erheblichen Fertigungstoleranzen behaftet sein können, ist eine genaue Positionierung besonders kritisch, insbesondere dann, wenn sehr genaue Positionierungen unterhalb von 20µm gefordert werden.

Es werden daher Genauigkeiten von +/- 5µm bis. +/- 20µm und Rotationsgenauigkeiten von +/- 5/10 µm äquivalent am notch (falls vorhanden am Trägersubstrat), bzw. am flat gefordert.

Die Trägersubstrataufnahme 4 ist durch das Rotationsmittel 6 drehbar gelagert und über die Trägereinheit 7 mit der Verstelleinrichtung 8 verbunden, die eine translatorische Bewegung der Trägereinheit 7 und damit der Trägersubstrataufnahme 4 ermöglicht. In der Trägereinheit 7 befindet sich eine (oder mehrere) optische Scaneinheit 15, 15'.

Die Scaneinheit 15, 15' ist in der Lage, die Umfangskonturen 2u, 5u der beiden Substrate 2, 5 zumindest abschnittsweise zu erfassen, insbesondere scannen. Die Entfernungsmesseinrichtung 11 erlaubt dabei die, insbesondere kontinuierliche, Ermittlung des Abstandes vom Distanzmesssystem 11 zu den Umfangskonturen 2u, 5u.

Dadurch entsteht ein Abstandsprofil, das gleichzeitig die Außengeometrie der beiden Substrate 2, 5 vermisst/erfasst. Dieses Abstandsprofil ergibt sowohl den größten äußeren Durchmesser des jeweiligen Substrates 2, 5 als auch den Abstand der Umfangskonturen 2u, 5u der einzelnen Substrate 2, 5 zueinander. Bevorzugt rotieren die Scanneinheiten 15, 15' entlang der Führungselemente 10 in der mechanischen Vorrichtung.

Durch die Rotation der Scaneinheiten 15, 15' ist es möglich, die Substratkanten 2u, 5u der beiden Substrate 2, 5 zu vermessen und zugleich die Lage der beiden Substrate 2, 5 zueinander zu ermitteln. Die Scaneinheiten 15, 15' können sich entlang eines geschlossenen Kreises bewegen, sofern die Führung 10 geschlossen ist, oder nur entlang von Kreissegmenten 10, wie in der Ausführungsform in Fig. 1b gezeigt. Für weniger genaue Justieranforderungen kann auf die Rotation der Scaneinheiten 15, 15' verzichtet werden. Es ist auch möglich die Scaneinheiten 15, 15' nicht zu rotieren, sondern die beiden Substrate 2, 5 bei feststehenden Scaneinheiten 15, 15' zu rotieren, indem entsprechende Kontaktierungsmittel 3 Rotationseinheiten aufweisen.

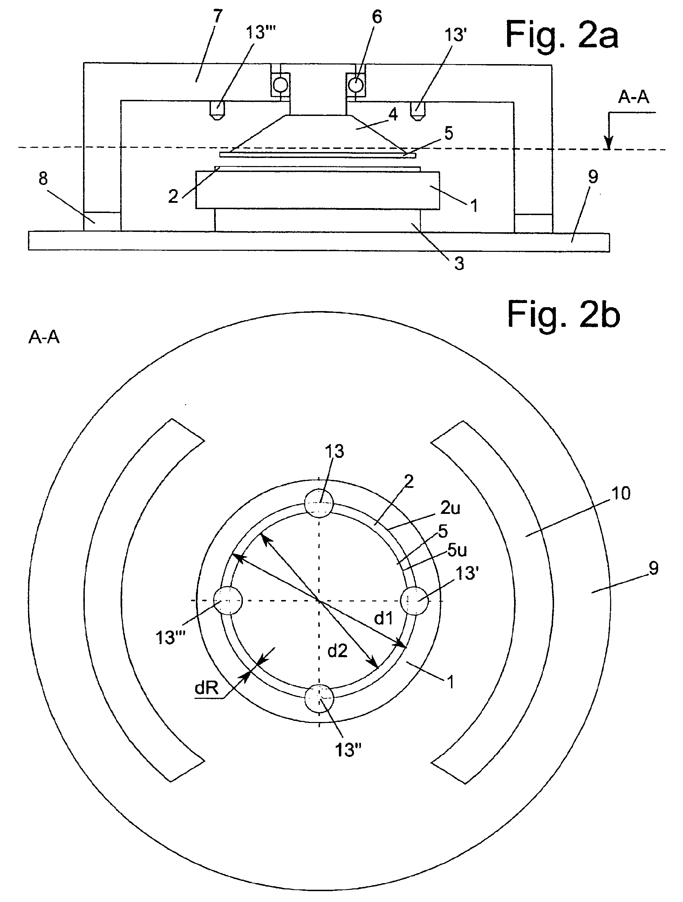

In der Ausführungsform gemäß Fig. 2a und 2b kann es sich bei den Scaneinheiten um Optiken 13, 13', 13", 13"' handeln, deren optische Achsen ungefähr im rechten Winkel zur Substratoberfläche des Substrats 2 steht. In einer speziellen Ausführungsform handelt es sich um Mikroskope, die ein optisches Bild der Substratkanten und somit der Umfangskonturen 2u, 5u zur Messung und Auswertung liefern.

Eines oder mehrere dieser Optiken 13, 13', 13", 13"' können wiederum beweglich (rotierend um die stehenden Substrate 2, 5) oder stationär (mit rotierenden Substraten 2, 5) angeordnet sein

In einem weiteren Spezialfall sind mindestens vier Optiken 13, 13', 13", 13"' stationär am Umfang über und/oder unter den Substraten 2,5 angeordnet. Beide Substratkanten 2u, 5u sind durch die Optiken 13, 13', 13", 13"' sichtbar (ggf. unter umfokussieren aufgrund des Z-Abstandes der die Tiefenschärfe übersteigen könnte).

In dieser Ausführungsform ist es vorteilhaft, wenn das Trägersubstrat 5 mit dem geringeren Durchmesser d2 im optischen Pfad zwischen den Optiken 13, 13', 13", 13"' und dem Substrat 2 mit dem größeren Durchmesser d1 liegt, damit für die Optiken 13, 13', 13", 13'" beide Umfangskonturen 2u, 5u bei entsprechender Ausrichtung der beiden Substrate 2, 5 zueinander gleichzeitig sichtbar sind.

Sollten die Optiken sensitiv für eine elektromagnetische Strahlung sein, für welche die verwendeten Substrate transparent sind, kann das Substrate 2 mit dem größeren Durchmesser d1 sich auch näher an der jeweiligen Optik befinden. Beispielhaft genannt seien Siliziumwafer, die für Infrarotstrahlung transparent sind.

Mathematisch kann die Justierung der beiden Substrate 2, 5 zueinander durch jede beliebige Ausgleichsrechnung, vorzugsweise durch die Methode der kleinsten Quadrate, durchgeführt werden. Die Optiken oder Distanzmesssysteme sind vorzugsweise so auszuführen sind, dass die aufgenommenen Daten digitalisiert werden und an einen entsprechenden Computer weitergeleitet werden können.

Eine entsprechende Software im Computer (Steuerungseinrichtung) ist in der Lage, die X- und/oder Y- und/oder Rotationseinheiten so anzusteuern, dass eine kontinuierliche Anpassung der Ausrichtung der beiden Umfangskonturen 2u, 5u zueinander erfolgt und zwar solange, bis die entsprechende Ausgleichsrechnung der Software einen Parameter liefert, welcher ein Maß für die Genauigkeit der Ausgleichsrechnung ist, der einen vom Benutzer vorgegebenen Schwellwert unterschreitet.

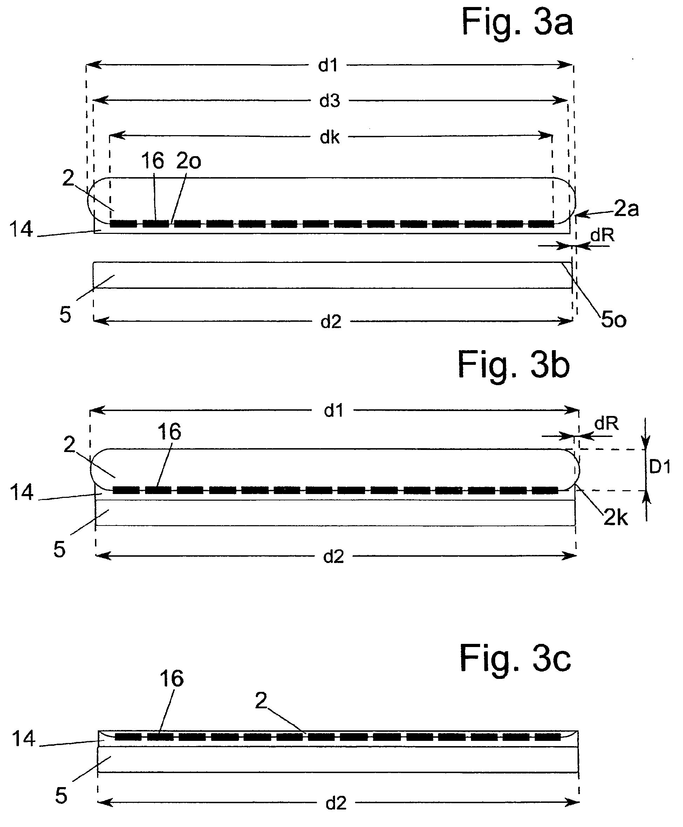

Die Figuren 3a-3c zeigen ein Ausführungsbeispiel gemäß der Erfindung. Die Figuren 3a-3b zeigen einen verkürzten Prozess zur Herstellung eines Produkts (Substrat-Trägersubstrat-Kombination), mit dem Trägersubstrat 5, dessen Durchmesser d2 zumindest vor dem Rückdünnprozess (Fig. 3a-3b) kleiner ist als der Durchmesser d1 des Substrats 2. Nach einem Ausrichtungs- und Bondprozess (Fig. 3b) erfolgt ein Rückdünnprozess des Substrats 2 (Fig. 3c).

Das Substrat 2 wird mit dem Trägersubstrat 5 durch eine Klebeschicht 14 verbunden, die vor dem Bonden auf das Substrat 2 aufgebracht wird, insbesondere mit einer Klebefläche mit einem Durchmesser d3, der zwischen dem Durchmesser d2 des Trägersubstrats 5 und dem Durchmesser d1 des Substrats 2 liegt, vorzugsweise dem Durchmesser d2 des Trägersubstrats 5 im Wesentlichen entspricht.

In dem Ausführungsbeispiel gemäß Fig. 3 weist das Trägersubstrat 5 einen sehr kleinen Kantenradius auf, während das Substrat 2 einen sehr großen Kantenradius besitzt. In dem Ausführungsbeispiel erhält man dadurch zwei Vorteile. Erstens trägt der relativ kleine Kantenradius des Trägersubstrats 5 dazu bei, dass eine das Substrat 2 nach Aufnahme auf dem Trägersubstrat 5 stützende Stützfläche 5o so weit wie möglich an eine Auflagekante 2k der Umfangskontur 2u reicht, was eine vorteilhafte Stützung des Produktsubstrats 2 durch das Trägersubstrat 5 zur Folge hat. Die Klebeschicht 14 hat keinen wesentlichen Einfluss auf die Stützung, zumal diese mindestens den Durchmesser d3 gleich dem Durchmesser d2 des Trägersubstrats 5 aufweist.

Durch den Kantenradius weist das Substrat 2 an seiner Umfangskontur zumindest an der Kontaktseite 2o des Substrats 2 mit dem Trägersubstrat 5 einen ringförmigen Absatz 2a auf, der eine Ringbreite dR hat, die mindestens der Differenz der Durchmesser d2 und d1 entspricht. Der Absatz 2a zeichnet sich bei dieser Ausführungsform durch kontinuierliche Verringerung der Dicke D₁ des Substrats 2 in Richtung der Umfangskontur 2u und/oder durch kontinuierliche Verringerung des Durchmessers vom (maximalen) mittleren Durchmesser d1 bis zu einem Durchmesser dk an der Kontaktseite 2o aus. Der Absatz 2a kann insbesondere durch die Klebeschicht 14, insbesondere durch einen Durchmesser d3 der Klebeschicht 14, definiert sein.

Des Weiteren erlaubt der relativ große Kantenradius des Produktsubstrats 2, dass der Durchmesser d1 des Produktsubstrats 2 alleine durch das Rückdünnen und die Form des Querschnitts der Umfangskontur 2u an den Durchmesser d2 des Trägersubstrats 5 angepasst wird.

Nach einem Ausrichtungs- und Bondprozess (Fig. 3b) erfolgt ein Rückdünnprozess des Substrats 2 (Fig. 3c) mindestens bis über den Absatz der Umfangskontur 2u, also mindestens bis zum Absatz 2a'.

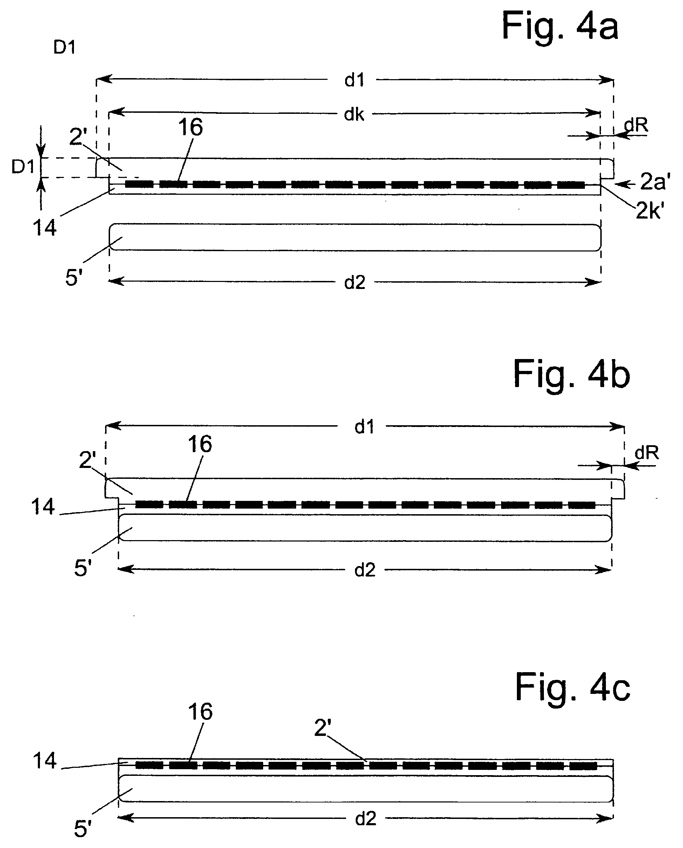

Die Figuren 4a-4b zeigen einen weiteren verkürzten Prozess eines Produkts (Substrat-Trägersubstrat-Kombination), der keinen Teil der Erfindung darstellt, mit einem Trägerwafer 5', dessen Durchmesser d2 kleiner ist als der Durchmesser d1 eines Substrats 2'. Der Rand des (Produkt-)substrats 2' wurde an der Umfangskontur 2u um eine Ringbreite dR zurückgeschliffen, um einen Effekt ähnlich dem Effekt des größeren Kantenradius bei der Ausführung gemäß Figuren 3a bis 3c zu erreichen. Hierdurch entsteht ein ringförmiger Absatz 2a. Das Zurückschleifen wird insbesondere durch ein in der Industrie unter dem Namen "edge-trimming" bekanntes Verfahren erzeugt.

Der Durchmesser d2 des Trägerwafers 5' entspricht mit Vorzug gleich dem um die Ringbreite dR des Kreisrings reduzierten Durchmesser d1 des Substrats 2. Nach einem Ausrichtungs- und Bondprozess (Fig. 4b) erfolgt ein Rückdünnprozess des Substrats 2' (Fig. 4c) mindestens bis auf den zurückgeschliffenen Abschnitt der Umfangskontur 2u, also mindestens bis zum Absatz 2a'.

Beide Produkte haben die Eigenschaft, dass der Durchmesser d2 des Trägerwafers 5, 5' und der Durchmesser d1 des Substrats 2, 2' nach dem Rückdünnen eine geringere Differenz aufweisen, insbesondere annähernd gleich oder der Durchmesser d1 sogar kleiner als der Durchmesser d2 ist, indem auf Grund der Kantenform des Substrats 2, 2' der Rückdünnprozess zu einer Reduktion des Durchmessers d1 des Substrats 2, 2' führt.

Die Kantenformen der Substrate sind durch Semistandards festgelegt. Es gibt Substrate mit unterschiedlichen, für spezielle Aufgaben vorgesehenen Kantenprofilen. Diese Kantenprofile werden durch spezielle Maschinen hergestellt. Die Form der Kanten ist insbesondere von Bedeutung für die Chipausbeute. Um möglichst viele Chips auf einem Substrat prozessieren zu können, müssen auch auf den äußersten Randbereichen Chips hergestellt werden. Daher ist es sinnvoll, die Kantengeometrie möglichst eckig, oder zumindest abgerundet mit möglichst geringen Rundungsradien herzustellen. Dadurch entsteht vorzugsweise ein Wafer mit möglichst großflächigem Nutzbereich.

Die unterschiedlichen Waferkantenprofile sind im SEMI Standard definiert. Die unterschiedlichen Waferkantenprofile können sehr komplizierte Formen annehmen und werden in den seltensten Fällen durch einen einzigen Parameter beschrieben. Erfindungsgemäß ist der Kantenradius als Parameter zu verstehen, der zu einer deutlichen Abrundung des Waferkantenprofils führt.

Für eine Ausführungsform, in welcher der Produktwafer möglichst viele funktionale Einheiten besitzen soll, ist der charakteristische Kantenradius kleiner als 1mm, mit Vorzug kleiner als 0.5mm, mit größerem Vorzug kleiner als 0.1mm, mit größtem Vorzug kleiner als 0.001mm, mit allergrößtem Vorzug gleich 0mm.

Für eine erfindungsgemäße Ausführungsform, in welcher der Produktwafer durch Prozesse nach dem Bondvorgang in seiner Dicke reduziert wird, hat die Berechnung des charakteristischen Kantenradius anhand der Enddicke des Produktwafers beziehungsweise dem Durchmesser des Träger- und/oder Produktsubstrats zu erfolgen. Der charakteristische Kantenradius ist größer als 0mm, mit Vorzug größer als 0.001 mm, mit größerem Vorzug größer als 0.1 mm, mit größtem Vorzug größer als 0.5mm, mit allergrößtem Vorzug größer als 1mm.

Für eine erfindungsgemäße Ausführungsform, in welcher der Trägerwafer den Produktwafer über eine möglichst große Fläche optimal stützen soll, ist der charakteristische Kantenradius des Trägerwafers kleiner als 1mm, mit Vorzug kleiner als 0.5mm, mit größerem Vorzug kleiner als 0.1mm, mit größtem Vorzug kleiner als 0.001mm, mit allergrößtem Vorzug gleich 0mm.

### Bezugszeichenliste

- 1: Substrataufnahme
- 2, 2': Substrat
- 2a, 2a': Absatz
- 2k, 2k': Auflagekante
- 2o: Kontaktseite
- 3: Kontaktierungsmittel
- 4: Trägersubstrataufnahme
- 5, 5k': Trägersubstrat
- 2u, 5u: Umfangskonturen
- 5o: Stützfläche
- 6: Rotationsmittel
- 7: Trägereinheit
- 8: Verstelleinrichtung
- 9: Grundplatte
- 10: Führungselemente
- 11: Entfernungsmesselemente
- 12: Messmittel
- 13, 13', 13", 13"': Optiken
- 14: Klebeschicht
- 15, 15': Scaneinheit
- 16: Funktionale Einheiten
- d1, d2, d3, dk: Mittlere Durchmesser
- dR: Mittlere Ringbreite
- D₁: Dicke

## Patentansprüche

1. Verfahren zur Herstellung einer Substrat-Produktsubstrat-Kombination durch Ausrichten, Kontaktieren und Bonden einer Kontaktseite (2o) eines flächigen Substrats (2) mit einer Stützfläche (5o) eines als Verstärkung des Substrats (2) dienenden Trägersubstrats (5), wobei das Substrat (2) beim Kontaktieren einen größeren mittleren Durchmesser d1 aufweist als der mittlere Durchmesser d2 des Trägersubstrats (5), wobei der mittlere Durchmesser d1, d2 am Maximum der Querschnittskontur gemessen wird, wobei das Substrat (2) nach dem Kontaktieren rückgedünnt wird und dadurch der mittlere Durchmesser d1 allein durch die Form des Querschnitts des Substrats (2) an dessen Umfangskontur (2u) auf d1 <= d2 verringert wird, wobei die Querschnittskontur des Substrats (2) auf der Kontaktseite (2o) einen sehr großen Kantenradius aufweist, um die Verringerung des mittleren Durchmessers zu ermöglichen.

## Claims

1. Process for producing a substrate-product substrate combination by aligning, bringing into contact, and bonding a contact side (2o) of a large-area substrate (2) to a support surface (5o) of a carrier substrate (5, 5') acting as an enforcement of the substrate (2), whereby the substrate (2) has a larger mean diameter d1 than the mean diameter d2 of the carrier substrate (5) when contacting, wherein the mean diameter d1, d2 is measured on the maximum of the cross sectional contour, wherein the substrate (2) is thinned after contacting and thereby the mean diameter d1 is reduced only by means of the form of the cross section of the substrate (2) at its peripheral contour (2u) to d1 ≤ d2, wherein the cross sectional contour of the substrate (2) on the contact side (2o) comprises a very large edge radius, in order to enable the reduction of the mean diameter.

## Revendications

1. Procédé de fabrication d'une combinaison de substrat-substrat de produit par l'alignement, la mise en contact et la liaison d'une face de contact (20) d'un substrat plan (2) à une face de support (50) d'un substrat porteur (5) servant de renfort du substrat (2), sachant que le substrat (2) présente lors de la mise en contact, un diamètre moyen d1 supérieur au diamètre moyen d2 du substrat porteur (5), sachant que le diamètre moyen d1, d2 est mesuré au maximum du contour de coupe transversale, sachant que le substrat (2) est aminci après la mise en contact et ainsi le diamètre moyen d1seul est réduit à son contour périphérique (2u) à d1 <= d2 par la forme de la section transversale du substrat (2), sachant que le contour de coupe transversale du substrat (2) sur la face de contact (20) présente un rayon d'arête très grand afin de permettre de réduire le diamètre moyen.
